Europäisches Patentamt

European Patent Office

Office européen des brevets

(11) Numéro de publication: **0 264 322 B1**

## FASCICULE DE BREVET EUROPEEN

(45) Date de publication de fascicule du brevet:
10.04.91

(51) Int. Cl.5: **H05K 13/04**, H01R 43/20

(21) Numéro de dépôt: 87402198.3

(22) Date de dépôt: 05.10.87

(54) Procédé pour le montage de composants électroniques sur une carte imprimée.

(30) Priorité: 08.10.86 FR 8614002

(43) Date de publication de la demande:
20.04.88 Bulletin 88/16

(45) Mention de la délivrance du brevet:
10.04.91 Bulletin 91/15

(84) Etats contractants désignés:
DE GB

(56) Documents cités:
EP-A- 0 126 563
US-A- 3 807 045
US-A- 4 328 613

(73) Titulaire: SOCAPEX
10 bis, quai Léon Blum
F-92153 Suresnes(FR)

(72) Inventeur: Cottet, Jacques François
Villa "Le Benettin"
F-74250 Viuz en Sallaz(FR)
Inventeur: Servoz, Serge Philippe
Villa "Troubois"
F-74500 Lugrin(FR)

(74) Mandataire: Clanet, Denis et al
Cabinet Beau de Loménie 55, rue d'Amsterdam
F-75008 Paris(FR)

**Description**

L'invention a pour objet un procédé pour le montage de composants électroniques sur une carte imprimée.

Le montage d'un composant sur une carte imprimée, par introduction de ses bornes de contact dans les trous métallisés de celle-ci avant soudage, devient une opération particulièrement délicate en raison de la miniaturisation des composants, de l'augmentation sensible du nombre de bornes et de la réduction de leur section.

EP-A-0 126563 décrit un outil d'alignement de bornes de composants électroniques, comportant deux peignes superposés interagissant l'un avec l'autre.

L'invention propose un procédé permettant de faciliter un tel montage grâce auquel les risques d'endommager une borne se trouvent sensiblement réduits.

Le procédé pour le montage d'un composant comportant un grand nombre de bornes de contact dans les trous métallisés d'une carte imprimée, lesdits trous étant organisés selon des rangées parallèles définissant une grille carrée, rectangulaire ou en quinconce, caractérisé en ce qu'il comporte les phases suivantes :

- on positionne et on fixe sur la carte imprimée deux peignes symétriques l'un par rapport à l'autre, chaque peigne comprenant des dents régulièrement espacées, rectilignes, parallèles entre elles avec une inclinaison correspondant aux diagonales des carrés, rectangles ou quinconces de la grille des trous métallisés, les bords desdites dents étant biseautés en convergeant vers le plan supérieur du peigne pour que les deux peignes superposés définissent sur la carte imprimée autour des trous métallisés des trémies de guidage en forme de losanges à bords inclinés facilitant l'insertion des extrémités libres des bornes dans les trous de la carte imprimée ;
- on fait pénétrer les extrémités libres des bornes dans les trémies puis dans les trous métallisés ;
- on désolidarise les peignes de la carte et l'un de l'autre ;
- on fait glisser les peignes sur la carte et l'un sur l'autre parallèlement à la direction de leurs dents respectives ;
- on complète l'enfoncement du composant dans les trous pour qu'il soit prêt pour les opérations de fixation sur la carte et le soudage subséquentes.

D'autres caractéristiques de l'invention apparaîtront à la lecture de la description qui va suivre et se rapporte aux dessins annexés dans lesquels :

- la Figure 1 montre le dessin géométrique d'une grille "carrée" de bornes de composants ou trous de la carte imprimée correspondante ;
- la Figure 2 montre le dessin d'une grille en quinconce ;
- la Figure 3 précise la disposition en quinconce de la Figure 2 ;
- la Figure 4 est une vue partielle, en plan, d'un des deux peignes selon l'invention ;
- la Figure 5 est une vue en coupe partielle selon la ligne 5-5 de la Figure 4 ;
- la Figure 6 est une vue partielle, en plan de l'autre des deux peignes selon l'invention ;
- la Figure 7 montre en plan l'ensemble des peignes des figures 4 et 6 positionnés pour recevoir les bornes d'un composant ;
- les Figures 8 et 9 sont des vues schématiques utilisées pour expliquer le procédé selon l'invention.

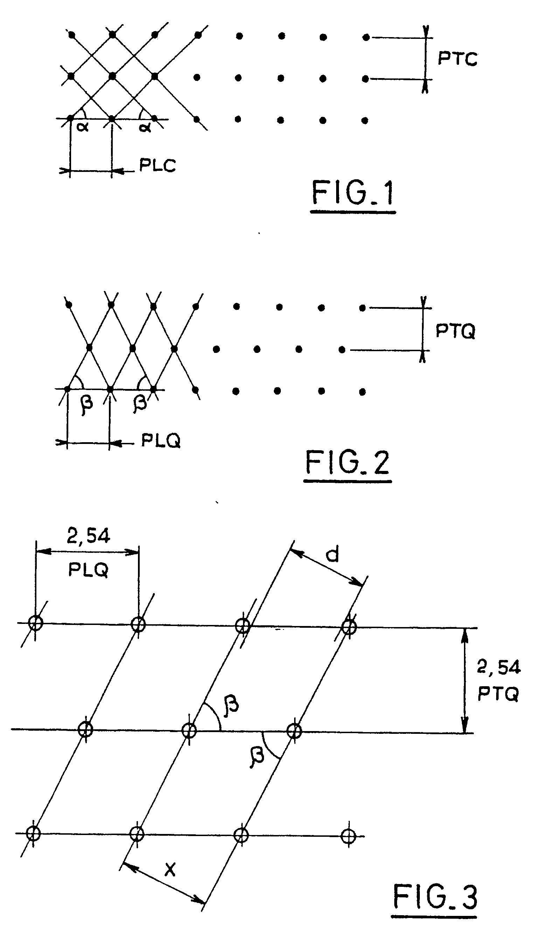

On a montré à la Figure 1 une partie des bornes d'un composant électronique, connecteur dit "à piquer sur carte", par exemple, organisées pour être piquées dans les trous d'une carte comportant une grille "carrée". On a désigné par PTC le pas transversal de la grille carrée et par PLC son pas longitudinal. On peut voir sur le dessin que la grille carrée présente des alignements (de bornes et par conséquent de trous) parallèles à l'axe longitudinal et parallèles à l'axe transversal du composant (non représenté) mais également des alignements selon des diagonales des carrés suivant des angles $\alpha = 45°$. A partir de la Figure 1, on peut aisément imaginer une grille rectangulaire auquel cas l'angl e $\alpha$ serait différent du 45°.

La Figure 2 montre une grille en quinconce (rectangle) dans laquelle le pas transversal est PTQ et le pas longitudinal PLQ.

On a désigné par $\beta$ l'angle des diagonales. Cet angle serait de 45° pour un quinconce carré.

La Figure 3 vient préciser le dessin de la Figure 2. Sur cette figure 3, apparaît la valeur du pas transversal PTQ égale à 2,54mm comme pour le pas longitudinal PLQ. L'angle $\beta$ est de 63°,30'. L'entre-axe entre bornes, mesuré perpendiculairement aux diagonales, est de $x = 2,272$ mm ce qui donne une distance effective entre bornes de $d = 1,772$ mm dans le cas où les bornes ont un diamètre de 0,5mm.

Les connecteurs actuels à piquer sur carte comportent plus de 250 bornes, généralement disposées en quinconce, en cinq rangées parallèles dans le sens longitudinal. La carte imprimée destinée à recevoir ces composants comporte des trous métallisés disposés selon la même grille et dont le diamètre est légèrement supérieur à celui des bornes.

On notera que les bornes peuvent également avoir une section carrée ou rectangulaire, leur extrémité libre étant plane, en pyramide ou arrondie.

On notera également que, généralement, une carte imprimée reçoit plusieurs composants dont les bornes sont organisées selon la même grille et qui sont montés côte à côte avec leurs axes longitudinaux parallèles et équidistants.

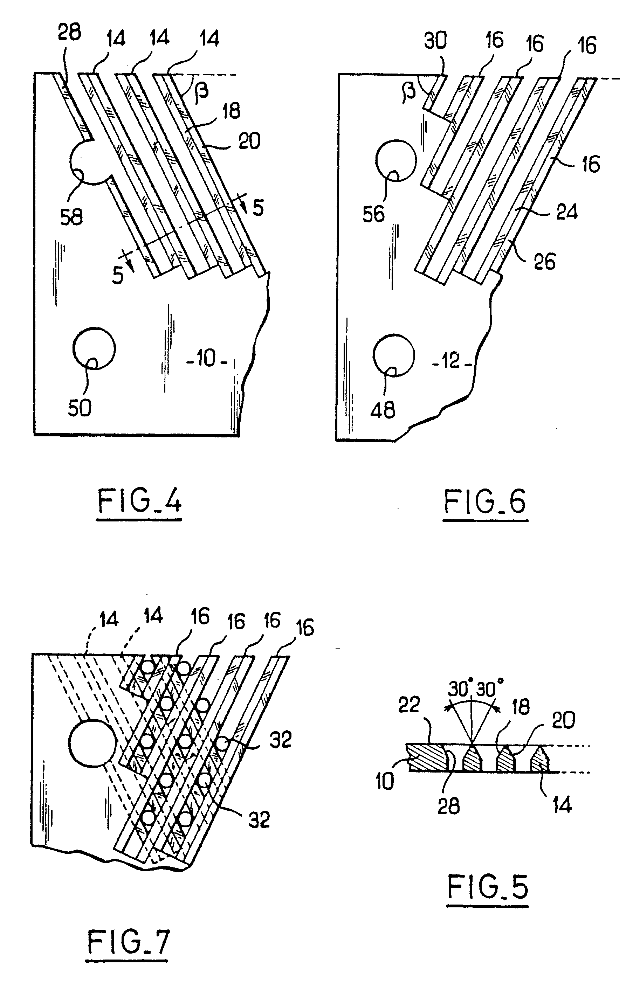

On décrira maintenant, en se référant aux Figures 4 à 7, l'outillage selon l'invention proposé pour faciliter le montage d'un composant sur une carte imprimée.

Cet outillage comporte deux peignes 10 (Fig.4) et 12 (Fig. 6) formés dans des plaques de tôle rectangulaires. Ces peignes, qui sont symétriques, comportent des dents parallèles, régulièrement espacées et de même section. (dents 14 pour le peigne 10, dents 16 pour le peigne 12). On a montré à la Figure 5 une coupe partielle du peigne 10 de la Figure 4 selon la ligne 5-5 de cette dernière ; on s'est abstenu de fournir une vue analogue du peigne 12 de la Figure 6 qui aurait été semblable. Dans les vues partielles de l'exemple représenté, on n'a montré que les premières dents (14 et 16) des deux peignes, lesquels en comportent un grand nombre pouvant dépasser la cinquantaine.

Comme le montre la Figure 5, chaque dent 14 est biseautée sur ses deux bords, et les faces biseautées 18-20 convergent dans le plan supérieur 22 du peigne 10. On a montré en 24 et 26, Figure 6, les faces biseautées des dents 16 du peigne 12.

En vis à vis de la première dent 14, à gauche si l'on considère la Figure 4, on a prévu un biseau 28, taillé dans la tôle du peigne 10. De même, on a prévu un biseau 30 sur le bord de la tôle du peigne 12 en face de la première dent 16.

L'inclinaison $\beta$ des dents 14 (ou 16) par rapport au bord supérieur de la tôle rectangulaire constituant le peigne 10 (ou 12) a été calculée de sorte que la superposition des deux peignes, comme montré à la Figure 7, permette l'obtention d'orifices en forme de losanges organisés pour entourer les trous 32 de la carte imprimée (Fig.7).

En d'autres termes les dents s'étendent en faisant avec l'axe longitudinal un angle $\beta$ qui est défini pour un composant donné par les caractéristiques du type de grille (pas transversal - pas longitudinal, voir Figure 3).

On conçoit qu'avec une telle disposition des trous 32 au milieu de la trémie définie par la superposition des biseaux des dents adjacentes des deux peignes qui se croisent, une borne 36 que l'on désire introduire dans un trou 32 se trouve guidée par un des biseaux d'une dent 16 puis par un des biseaux d'une dent 14 qui s'entrecroisent avec un angle $\beta$. La surface de la trémie en losange qui assure le guidage de l'extrémité libre d'une borne 36 destinée à pénétrer dans un trou 32 permet des tolérances beaucoup plus larges dans la position des extrémités des bornes à introduire dans la carte imprimée.

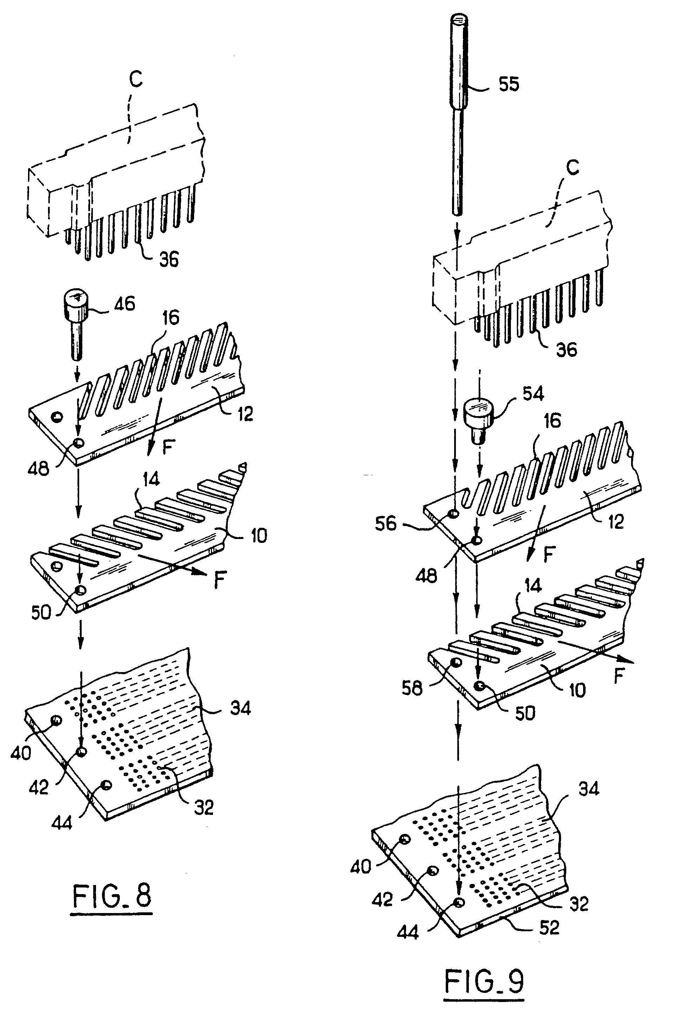

Lors de l'opération d'insertion des bornes dans les trous, les deux peignes sont positionnés et sont immobilisés entre eux et par rapport à la carte imprimée, les moyens utilisés à cet effet seront décrits ci-après en se référant aux Figures 8 et 9 qui sont des vues schématiques explicitant le procédé de montage d'un composant selon l'invention.

Sur les Figures 8 et 9, on retrouve les éléments qui ont été décrits plus haut à savoir: les deux peignes symétriques 10 et 12 comportant des dents 14 et 16 respectivement (lesquelles sont montrées sans leurs biseaux dans un but de simplification du dessin), la carte imprimée 34 et ses alignements de trous 32, les bornes 36 montées sur un composant C (connecteur par exemple).

Les connecteurs C sont généralement fixés sur une carte imprimée par deux éléments de fixation (rivet, vis par exemple), qui traversent leurs extrémités dans un plan de symétrie longitudinal et pénètrent dans des trous de fixation prévus dans la carte. On a montré trois de ces trous en 40,42 et 44 percés dans la carte 34 dans l'axe de symétrie des cinq rangées de trous métallisés 34 prévus pour recevoir les bornes 36 du compcsant C.

Si l'on considère la Figure 8, pour monter le composant C avec ses bornes 36 piquées dans les rangées de trous disposées en face du trou 40, on vient plaquer sur la carte 34 les peignes 10 et 12 au moyen d'un pion 46 dont la queue traverse successivement un orifice 48 du peigne 12, un orifice 50 du peigne 10 et le trou 42 de la carte. Une fois le positionnement et l'immobilisation assurés, on obtient au dessus des trous métallisés 32 correspondant au trou de fixation 40 du composant C les trémies de guidage en forme de losanges qui ont été décrites plus haut en se référant à la Figure 7. On fait pénétrer les bornes 36 du composant C dans les trous métallisés 32. Quand une bonne pénétration a été obtenue, on retire le pion 46 des trous 42,50 et 48. Les peignes 10 et 12 sont alors libérés et on les extrait en les faisant glisser sur la carte 34 (peigne 10) et entre eux (peignes 12 sur peigne 10) parallèlement à la direction de leurs dents respectives selon les flèches F du dessin de la Figure 8.

L'opération qui vient d'être décrite en se référant à la Figure 8, est aisément réalisée dans le cas de composants C disposés sur une carte avec un pas régulier, c'est à dire équidistance entre les trous de fixation 44-42, 42-40, etc... Elle est impossible lorsqu'on arrive au composant fixé à l'extrémité de la carte dans le trou 44. On a recours, dans ce cas, à une variante décrite en se référant à la Figure 9.

On retrouve sur cette figure les éléments décrits à la figure 8, à savoir la carte 34 avec ses trous métallisés 32 et ses trous de fixation 40,42 et 44 et les peignes 10 et 12 que l'on désire positionner au dessus des trous métallisés 32 correspondant au trou 44 au bord antérieur 52 de la carte 34 afin qu'ils définissent des trémies de guidage en losange pour les bornes 36 du composant C. Dans le cas de la Figure 9, les orifices 50 du peigne 10 et 48 du peigne 12 ne sont plus disposés au dessus de la carte mais au-delà de son bord antérieur 52 . On procède alors comme suit : on positionne les deux peignes 10 et 12 l'un par rapport à l'autre au moyen d'un pion 54 dont la queue, de longueur égale à la somme des épaisseurs des peignes, pénètre dans les orifices 48 et 50 (à chaque extrémité desdits peignes, une seule étant montrée sur le dessin). L'ensemble des deux peignes est positionné et immobilisé, à chacune de ses extrémités, au moyen d'une broche de guidage 55 qui traverse un trou de fixation prévu dans le composant, un orifice 56 et un orifice 58 des peignes (assemblés grâce aux pions 54) et le trou de fixation 44 du dernier composant de la carte. On pique le composant en le faisant coulisser sur les broches 55 et une fois ses bornes 36 engagées dans les trous métallisés 32 correspondant au trou de fixation 44, on extrait les broches 55 puis les pions 54 et on retire les peignes suivant les flèches F.

## Revendications

1. Procédé pour le montage d'un composant (C) comportant un grand nombre de bornes de contact (36) dans les trous métallisés (32) d'une carte imprimée (34), lesdits trous étant organisés selon des rangées parallèles définissant une grille carrée, rectangulaire ou en quinconce, caractérisé en ce qu'il comporte les phases suivantes :

   - on positionne et on fixe sur la carte imprimée (34) deux peignes (10-12) symétriques l'un par rapport à l'autre, chaque peigne comprenant des dents (14-16) régulièrement espacées, rectilignes, parallèles entre elles avec une inclinaison ($\beta$) correspondant aux diagonales des carrés, rectangles ou quinconces de la grille des trous métallisés (32), les bords (18-20, 24-26) desdites dents étant biseautés en convergeant vers le plan supérieur du peigne pour que les deux peignes (10-12) superposés définissent sur la carte imprimée autour des trous métallisés des trémies de guidage en forme de losanges à bords inclinés facilitant l'insertion des extrémités libres des bornes (36) dans les trous (32) de la carte imprimée (34) ;
   - on fait pénétrer les extrémités libres des bornes (36) dans les trémies puis dans les trous métallisés (32) ;
   - on désolidarise les peignes (14-12) de la carte et l'un de l'autre ;
   - on fait glisser les peignes sur la carte et l'un sur l'autre parallèlement à la direction (F) de leurs dents respectives ;
   - on complète l'enfoncement du composant (C) dans les trous (32) pour qu'il soit prêt pour les opérations de fixation sur la carte et de soudage subséquentes.

2. Procédé selon la revendication 1, caractérisé en ce qu'on positionne et on fixe, sur la carte imprimée (34), les deux peignes au moyen de pions (46) traversant des orifices (48, 50) traversant les peignes (12, 10) et un trou (42) de la carte (34).

3. Procédé selon la revendication 1, caractérisé en ce que l'on positionne les peignes (10, 12) l'un sur l'autre pour définir les trémies précitées au moyen de pions (54) dont la longueur est égale à la somme des épaisseurs des peignes (10-12-54) au moyen de broches (55) perpendiculaires à la carte (34) traversant successivement un trou de fixation prévu dans le composant puis les peignes et un trou de la carte et sur lesquelles on fait coulisser le composant (C-Fig.9) vers la carte (34).

## Claims

1. Process for mounting a component (C) comprising a large number of contact terminals (36) in the plated through-holes (32) of a printed circuit board (34), said holes being arranged in parallel rows defining a square or rectangular grid or a grid of staggered rows, characterised by comprising the following steps:
   - positioning and fixing onto the circuit board (34) two combs (10-12) symmetrical with respect to one another, each comb having regularly spaced, rectilinear teeth (14-16) which are parallel to one another at an angle (B) corresponding to the diagonals of the squares, rectangles or staggered-row configuration of the grid of plated through-holes (32), the edges (18-20, 24-26) of said teeth being bevelled and converging towards the upper face of the comb so that when superposed the two combs (10-12) define on the printed circuit board, around the plated through-holes, guide openings in the form of lozenges with sloping edges which make it easier to insert the free ends of the terminals (36) into the holes (32) of the printed circuit board (34);

- inserting the free ends of the terminals (36) into the openings and then into the plated through-holes (32);
- disconnecting the combs (14-12) from the board and from one another;
- sliding the combs over the board and over one another parallel to the direction (F) of their respective teeth;
- finishing pushing the component (C) into the holes (32) so that it is ready for the subsequent operations of fixing it on the board and welding it.

2. Process according to claim 1, characterised by positioning and fixing the two combs onto the printed circuit board (34) by means of pegs (46) which pass through orifices (48, 50) running through the combs (12, 10) and a hole (42) in the board (34).

3. Process according to claim 1, characterised by positioning the combs (10, 12) on top of one another so as to define the aforesaid openings by means of pegs (54) whose length is equal to the sum of the thicknesses of the combs (10-12-54), by means of pins (55) perpendicular to the board (34) which pass successively through a fixing hole provided in the component and then through the combs and a hole in the board, and over which pins the component (C - Fig. 9) is slid towards the board (34).

**Ansprüche**

1. Verfahren zum Bestücken eines eine größere Anzahl von Kontaktstiften (36) aufweisenden Bauteils (C) in den metalisierten Löchern (32) einer Leiterplatte (34), wobei die Löcher in parallelen Reihen unter Bildung eines quadratischen, rechteckigen oder versetzten bzw. zickzackförmigen Lochmusters angeordnet sind, gekennzeichnet durch folgende Verfahrensschritte:

   - Positionieren und Befestigen von zwei zueinander symmetrischen Kämmen (10-12) auf der Leiterplatte (34), wobei jeder Kamm Zähne (14-16) aufweist, die zueinander regelmäßig beabstandet, geradlinig und parallel in einer Schräge (ß) verlaufen, welche den Diagonalen der Quadrate, Rechtecke oder Versetzungen bzw. dem Zickzack der Lochmuster der metallisierten Löcher (32) entspricht, wobei die Ränder (18-22, 24-26) dieser Löcher abgeschrägt sind, damit die beiden übereinander angeordneten Kämme (10-12) auf der Leiterplatte um die metallisierten Löcher herum romben- oder rautenförmige Führungstaschen um die schrägen Ränder herum bilden, um dadurch das Einsetzung der freien Ende der Kontaktstifte (36) in die Löcher (32) der Leiterplatte (34) zu erleichtern;
   - Einschieben der freien Ende der Kontaktstifte (36) in die Führungstaschen und danach in die metallisierten Löcher (32);
   - Trennen der Kämme (14-12) nacheinander von der Leiterplatte;
   - Verschieben der Kämme auf der Leiterplatte und zueinander parallel in Richtung (F) der jeweiligen Kammzähne;
   - Komplettieren des Einsetzens des Bauteils (C) in die Löcher (32), um sie für die nachfolgenden Fixierungsvorgänge auf der Leiterplatte und den Lötvorgang vorzubereiten.

2. Verfahren nach Anspruch 1, gekennzeichnet durch das Positionieren und Fixieren der beiden Kämme mit Stiften (46) auf der Leiterplatte (34), wobei die Stifte (46) durch die durch die Kämme (12, 10) hindurchgehenden Löcher (48, 50) und ein Loch (24) in der Leiterplatte (34) hindurchgehen.

3. Verfahren nach Anspruch 1, gekennzeichnet durch das Positionieren der Kämme (10, 12) zur Schaffung der besagten Führungstaschen mittels Stiften (54) deren Länge gleich der Summe der Dicke der Kämme (10-12-54) ist, mittels senkrecht zur Leiterplatte (34) verlaufenden Stiften (55), die nacheinander ein im Bauteil vorgesehenes Befestigungsloch und dann die Kämme und ein Loch in der Leiterplatte durchdringen und auf denen das Bauteil (C-Fig. 9) bezüglich der Leiterplatte (34) verschoben wird.

FIG.1

FIG.2

FIG.3

FIG_4

FIG.6

FIG_5

FIG_7

C

36

46

16

12

F

48

14

10

F

50

34

40

42

44

32

FIG. 8

55

C

36

54

16

56

12

F

48

14

10

F

58

50

34

40

42

44

32

52

FIG. 9